# EUROPEAN PATENT APPLICATION

(11) **EP 2 804 180 A1**
(43) Date of publication of application: **19.11.2014**
(21) Application number: 13290108.3
(22) Date of filing: 15.05.2013
(51) Int. Cl.: G11C 11/16, G11C 11/56

(54) **Multilevel MRAM for low consumption and reliable write operation**

(71) Applicant: Crocus Technology S.A., 38025 Grenoble Cedex (FR)
(72) Inventor: Alvarez-Hérault, Jérémy, 38000 Grenoble (FR); Lombard, Lucien, 38000 Grenoble (FR); Bandiera, Sébastien, 38700 La Tronche (FR); Prejbeanu, Ioan Lucian, 38170 Seyssinet Pariset (FR)
(74) Representative: P&TS SA (AG, Ltd.)

(57) **Abstract**

Multilevel MRAM cell (1) comprising a magnetic tunnel junction (2) comprising a storage layer (23) having a storage magnetization (230), a reference layer (21) having a reference magnetization (210) and a barrier layer (22) between the storage and reference layer (23, 21); the magnetic tunnel junction (2) further comprising an antiferromagnetic layer (24) exchange-coupling the storage layer (23) such as to pin the storage magnetization (230) at a low temperature threshold and free it at a high temperature threshold; the storage magnetization (230) comprises a micromagnetic object (6, 7) that is movable within the storage layer (23) when a magnetic tunnel junction (2) is at the high temperature threshold and the write magnetic field (42) is applied; the resistance of the magnetic tunnel junction (2) being determined by the relative position of the micromagnetic object (6, 7) in the storage layer (23). The MRAM cell allows for writing with lower power consumption and improved reliability compared to conventional MRAM cells.

## Description

### Field

The present disclosure concerns a multilevel thermally assisted MRAM cell for writing a plurality of data states with lower power consumption and improved reliability compared to conventional MRAM cells.

### Description of related art

Conventional MRAM cells comprise a magnetic tunnel junction comprising a ferromagnetic reference layer having a fixed magnetization and a ferromagnetic storage layer. The resistance of the cell is determined by the orientation of the storage layer magnetization relative to the orientation of the reference layer magnetization. For example, when the magnetizations of the two layers are oriented parallel the resistance is low (corresponding to a data state "0"). Conversely, when the magnetizations of the two layers are oriented anti- parallel the resistance is high (corresponding to a data state "1").

In thermally-assisted-switching (TAS) MRAM cells, the storage layer magnetization can be pinned by an antiferromagnetic layer when the magnetic tunnel junction is at a low threshold temperature, being at or below a blocking temperature of the antiferromagnetic layer. During a writing operation, the magnetic tunnel junction is heated above the blocking temperature, or at a high threshold temperature, such as to free the storage layer magnetization. The blocking temperature is typically between 150°C to 300°C such that TAS MRAM cells have increased stability at normal operating temperatures, i.e., when the MRAM cell is not written. In other words, the pinned storage layer magnetization is not affected by external fields and noise.

The same advantage applies in the case of self-referenced TAS MRAM cells, wherein the orientation of the reference layer magnetization can be freely varied with an external applied magnetic field. During a reading operation of the self-referenced TAS MRAM cell, the orientation of the reference layer magnetization is varied and compared to the storage layer magnetization being pinned.

MRAM cells with a multilevel state write operation have also been proposed, allowing for writing more than the two level states "0" and "1" as described above. Such multilevel MRAM cell can be based on orienting the storage layer magnetization in various intermediate positions between the parallel and antiparallel orientations using relatively low magnetic fields. Such multilevel MRAM cells require at least two current lines increasing the complexity of the cell. Moreover, it is difficult to obtain reproducible write at low field due to variations in the orientation of storage layer magnetization caused by irregularities in the storage layer. Such irregularities are typically shape and/or edge roughness generated by the fabrication process of the storage layer.

### Summary

The present disclosure concerns a MRAM cell comprising a magnetic tunnel junction comprising a storage layer having a storage magnetization, a reference layer having a reference magnetization and a barrier layer between the storage and reference layer; the magnetic tunnel junction further comprising an antiferromagnetic layer exchange-coupling the storage layer such as to pin the storage magnetization at a low temperature threshold and free it at a high temperature threshold; the storage layer being arranged such that the storage magnetization comprises a micromagnetic object that is movable within the storage layer (23) when the magnetic tunnel junction is at the high temperature threshold and a write data is applied; the resistance of the magnetic tunnel junction being determined by the relative position of the micromagnetic object in the storage layer within the storage layer.

In an embodiment, said micromagnetic object can comprise a magnetic vortex with a vortex center, the resistance of the magnetic tunnel junction being determined by the position of the vortex center within the storage layer. The storage layer can have an aspect ratio below 3.

In another embodiment, said micromagnetic object can comprise a domain wall defining two magnetic domains; and the resistance of the magnetic tunnel junction can be determined by the relative size of the two magnetic domains, which is determined by the domain wall position. The storage layer can have an aspect ratio being comprised between 1.5 and 5. The storage layer can be rectangular, diamond or elliptical shaped.

In yet another embodiment, the storage layer can have a thickness being smaller than 200 nm and preferably smaller than 20 nm. The storage layer can further comprise a FeNi -based alloy.

In yet another embodiment, the reference magnetization can be fixed or can be freely switchable with an external applied magnetic field.

The present disclosure also pertains to a method for writing to the MRAM cell comprising:
heating the magnetic tunnel junction to the high temperature threshold;
applying the write data such as to move the micromagnetic object of the storage magnetization; and
cooling the magnetic tunnel junction to a low temperature threshold such as to pin the storage magnetization and the position of the micromagnetic object.

In an embodiment, applying the write data comprises passing a field current in the MRAM cell such as to generate a write magnetic field adapted for moving the vortex center or domain wall. Applying the write data can comprise passing a spin-polarized current in the magnetic tunnel junction, the domain wall or the vortex center position being determined by the magnitude and polarity of the spin-polarized current.

In another embodiment, said write data can be applied such as to move the micromagnetic object to a plurality of distinct positions corresponding to a plurality of distinct magnetoresistance values, respectively. The plurality of distinct positions can be comprised between two and ten such that the magnetoresistance of the magnetic tunnel junction can be varied between two and ten distinct values.

The MRAM cell disclosed herein allows for writing a plurality of data states with lower power consumption and improved reliability compared to conventional MRAM cells.

### Brief Description of the Drawings

The disclosure will be better understood with the aid of the description of an embodiment given by way of example and illustrated by the figures, in which:
Fig. 1 illustrates a MRAM cell comprising a storage layer, according to an embodiment;
Fig. 2 shows the storage layer comprising a single magnetic vortex with a vortex center, according to an embodiment;
Fig. 3 shows the storage layer comprising a domain wall, according to an embodiment; and
Fig. 4 represents a writing operation with the MRAM cell such as to perform multi-level writing.

### Detailed Description of possible embodiments

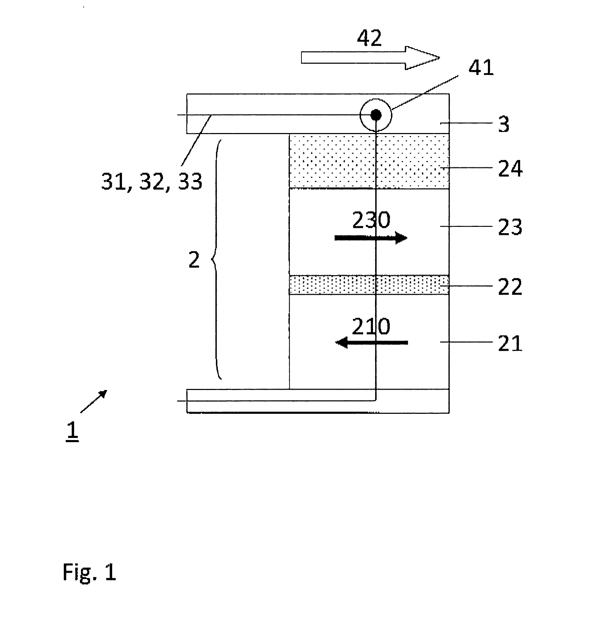

Fig. 1 illustrates a MRAM cell 1 according to an embodiment. The MRAM cell 1 comprises a magnetic tunnel junction 2 comprising a storage layer 23 having a storage magnetization 230, a reference layer 21 having a reference magnetization 210 and a barrier layer 22 between the storage and reference layer 23, 21. The magnetic tunnel junction 2 further comprises an antiferromagnetic layer 24 exchange-coupling the storage layer 23 such as to pin the storage magnetization 230 at a low temperature threshold and free it at a high temperature threshold. The MRAM cell 1 further comprises a current line 3 in electrical contact with one end of the magnetic tunnel junction 2. The current line 3 is arranged for passing a write data 33, 41.

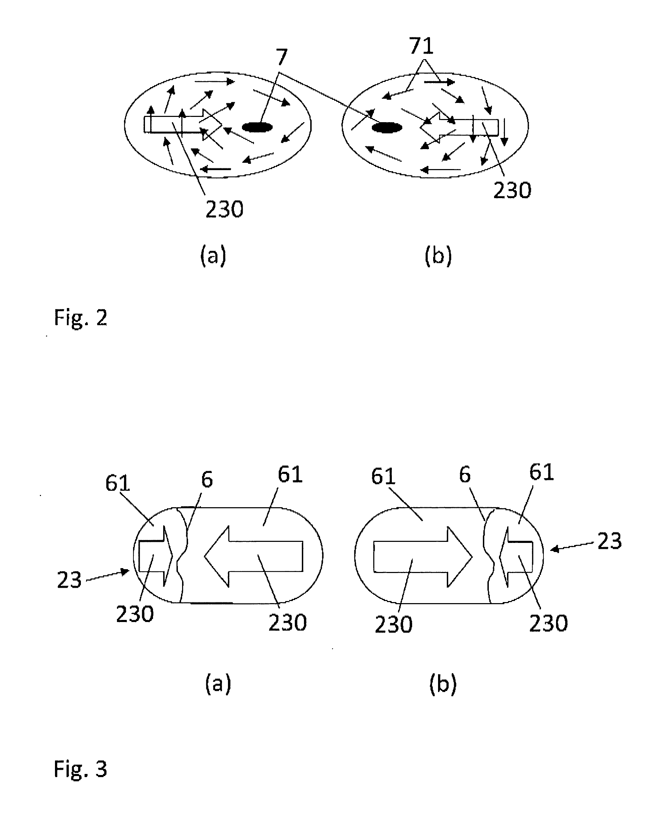

In an embodiment illustrated in Fig. 2, the storage layer 23 is arranged such that the storage magnetization 230 comprises a single magnetic vortex 71 within the storage layer 23. The vortex 71 comprises a micromagnetic object, or vortex center 7 in the storage layer 23, with magnetization perpendicular to the plane of the storage layer 23 and the main part of the magnetization 230 with an in-plane flux-closure magnetization distribution. The direction and the magnitude of the storage magnetization 230 depend on the position of the magnetic vortex 7. In Fig. 2, the configuration of the magnetic vortex 71 is represented by the little arrows. The magnetic vortex 71 can be moved by applying the write data 33, 41 when the magnetic tunnel junction 2 is heated at the high temperature threshold. The movement of the vortex center 7, and thus of the magnetic vortex 71, results in the storage magnetization 230 being oriented in a first direction (Fig. 2a) or in a second direction (Fig. 2b) opposed to the first direction. A resistance R of the magnetic tunnel junction 2 is thus determined by the orientation and the magnitude of the storage magnetization 230, depending in turn of the position of the vortex center 7.

In another embodiment shown in Fig. 3, the storage layer 23 is arranged such that the storage magnetization 230 comprises a micromagnetic object, or domain wall 6, defining two magnetic domains 61 with opposite magnetization. The domain wall 6 can be moved by applying the write magnetic field 42 when the magnetic tunnel junction 2 is heated at the high temperature threshold. The orientation of the storage magnetization 230 in one of the two magnetic domains 61 is opposed to the orientation of the storage magnetization 230 in the other magnetic domain 61. The resulting storage magnetization 230 thus depends on the relative size of the two magnetic domains 61 being in turn determined by the position of the domain wall 6. The resistance R of the magnetic tunnel junction 2 is thus determined by the position of the domain wall 6. For example, Fig. 3a shows the storage layer 23 where the domain wall 6 is positioned such that the magnetic domain 61 on the right side is larger than the one on the left side, such that the resulting storage magnetization 230 being oriented towards the left. In Fig. 3b, the domain wall 6 is positioned such that the magnetic domain 61 on the left side is larger than the one on the right side such that the resulting storage magnetization 230 being oriented towards the right.

In an embodiment, a method for writing to the MRAM cell 1 comprises:
heating the magnetic tunnel junction 2 to the high temperature threshold;
applying the write data 33, 41 such as to move the vortex center 7 or domain wall 6 of the storage magnetization 230, such as to write a data state in the storage layer 23; and
cooling the magnetic tunnel junction to a low temperature threshold such as to pin the storage magnetization 230.

Heating the magnetic tunnel junction 2 can be performed by passing a heating current 32 in the magnetic tunnel junction 2 via the current line 3. Cooling (in the absence of the heating current 32) is required for stabilizing the position of the vortex center 7 or domain wall 6 and thus, stabilizing the written data state.

In an embodiment, applying the write data is performed by passing a write field current 41 in the MRAM cell 1 such as to generate a write magnetic field 42 adapted for moving the vortex center 7 or domain wall 6. The domain wall 6, or the vortex center position 7, is determined by the magnitude and polarity of the write field current 41. Passing the write field current 41 in the MRAM cell 1 can comprise passing the write field current 41 in the current line 3 or in another current line (not shown) that can be controlled independently from the current line 3.

In another embodiment, applying the write data is performed by passing a spin-polarized current 33 in the magnetic tunnel junction 2 via the current line 3. The spin-polarized current 33 exerts a torque on the storage magnetization 230 and the domain wall 6, or the vortex center position 7, is determined by the magnitude and polarity of the spin-polarized current 33.

In the case the reference magnetization 210 of the reference layer 21 is fixed, a read operation of the MRAM cell 1 can comprise a step of passing a read current 31 in the magnetic tunnel junction, for example via the current line 3. The voltage measured across the magnetic tunnel junction 2 yields the resistance R of the magnetic tunnel junction 2, which value depends on the orientation of the fixed reference magnetization 210 relative to the resulting orientation of the storage magnetization 230.

In the case the reference magnetization 201 can be freely varied, a self-referenced read operation of the MRAM cell 1 can comprise:
applying a first read magnetic field 52 for aligning the sense magnetization 210 in a first direction,
comparing the first direction of the sense magnetization 210 with the resulting storage magnetization 230 by passing the read current 31 though the magnetic tunnel junction 2, such as to measure a first resistance value R₁ of the magnetic tunnel junction 2;
applying a second read magnetic field 53 for aligning the sense magnetization 210 in a second direction opposed to the first direction; and
comparing the second direction of the sense magnetization 210 with the resulting storage magnetization 230 by passing the read current 31 though the magnetic tunnel junction 2, such as to measure a second resistance value R₂ of the magnetic tunnel junction 2.

The first and second read magnetic field 52, 53 can be applied by passing a read field current 51 in the current line 3, wherein the read field current 51 has a first polarity and a second polarity opposed to the first polarity, respectively. For illustrative purposes, the write field current 41 and the read field current 51 with the first polarity are represented in Fig. 1 exiting the page and the corresponding write magnetic field 42 and first read magnetic field 52, respectively, by the arrow drawn with a plain line. The read field current 51 with the second polarity is represented entering the page and the second read magnetic field 53 is represented by the arrow in phantom line. The first resistance value R₁ can be compared with the second resistance value R₂ such as to determine the data written in the MRAM cell 1.

The storage magnetization 230 having a single domain wall 6 can be obtained by the storage layer 23 having a shape with a high aspect ratio. The shape of the storage layer 23 can be further optimized such as to facilitates the propagation of the domain wall 6. A high aspect ratio of the storage layer 23 allows for increasing the length of accessible position of the domain wall 6 in the pillar, thus increasing the resistance difference between the different stored states. However, the aspect ratio should not be too high such as to avoid having more than one domain wall 6 in the storage layer 23. Preferably, the storage layer 23 has an aspect ratio being comprised between 1.5 and 5.

For example, the storage layer 23 can have a rectangular shape, allowing moving the domain wall 6 or the vortex center 7 with the write magnetic field 42 having a magnitude being comprised between 5 Oe and 100 Oe, and preferably between 10 Oe and 20 Oe (corresponding to the write field current 41 having a few milliamps).

The rectangular shape of the storage layer 23 can further have rounded edges such as to ensure a proper magnetic state with a unique domain wall 6 or vortex center 7.

The storage layer 23 can further have a diamond shape or an elliptical shape.

In the case the storage magnetization 230 comprises a magnetic vortex 71, the storage layer 23 can have a small aspect ratio, preferably below 3. For example, the storage layer 23 can be circular or square-shaped.

The storage layer 23 can further have a thickness being smaller than 200 nm and preferably smaller than 20 nm.

The storage layer 23 can further comprise a FeNi -based alloy or any alloy that allows for stabilizing the domain wall 6 or the vortex center 7.

In an embodiment, the write magnetic field 42 is applied such that the vortex center 7 or domain wall 6 of the storage magnetization 230 can be moved in a plurality of distinct positions, such as to write a plurality of data states in the MRAM cell 1.

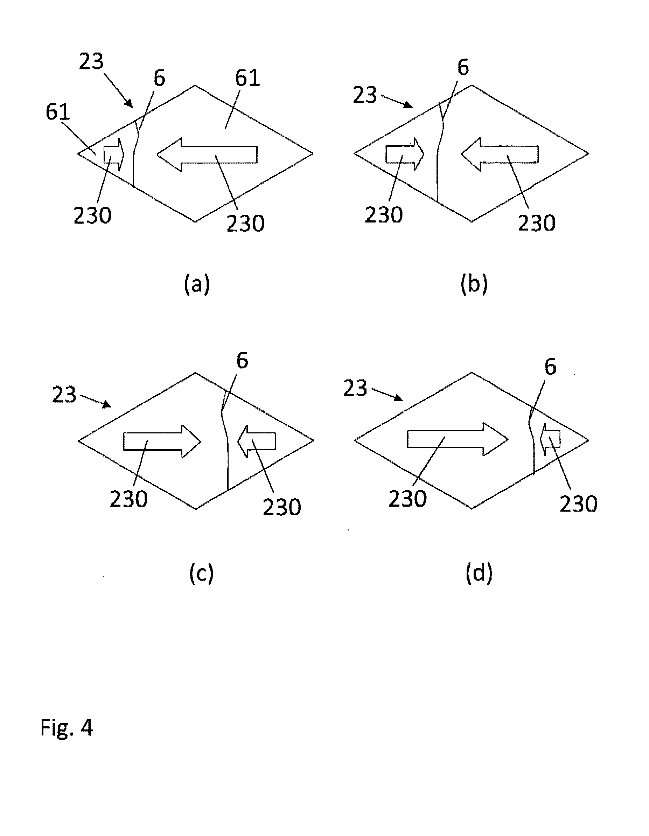

In an exemplary embodiment represented in Fig. 4, the write data 33, 41 is applied such as to move the domain wall 6 of the storage magnetization 230 in four distinct positions. In particular, Fig. 4a shows the domain wall 6 being moved in a first position such that the first magnetic domain 61 with the storage magnetization 230 oriented towards the right is much smaller than the second magnetic domain 61 with the storage magnetization 230 oriented towards the left, resulting in the storage magnetization 230 being substantially oriented towards the left and having a large magnitude. Fig. 4d shows the domain wall 6 being moved in a fourth position such that the second magnetic domain 61 with the storage magnetization 230 oriented towards the left is much smaller than the first magnetic domain 61 with the storage magnetization 230 oriented towards the right, resulting in the storage magnetization 230 being substantially oriented towards the right and having a large magnitude. Figs. 4b and 4c shows the second and third intermediate positions of the domain wall 6 where the magnetic domains 61 are such that a small resulting storage magnetization 230 is oriented towards the left (Fig. 4b) or towards the right (Fig. 4c) and having a smaller magnitude than in case a and d.

Each distinct position of the domain wall 6 corresponds to a distinct resistance R of the magnetic tunnel junction 2. Assuming the reference magnetization 210 is fixed and oriented towards the left in Fig. 4, the resistance R of the magnetic tunnel junction 2, measured during the read operation, will yield a resistance value R₁ that is minimum in the configuration of Fig. 4a and increasing from the first intermediate value R₂ (configuration of Fig. 4b) to the second intermediate value R₃ (configuration of Fig. 4c), and maximum R₄ in the configuration of Fig. 4d.

In a preferred embodiment, the distinct positions of the domain wall 6 are such that the difference in resistance R of the magnetic tunnel junction 2 between each position (or the difference between R₁, R₂, R₃ and R₄) is substantially equal. The equal difference between each subsequent resistance R₁, R₂, R₃ and R₄ can be obtained for example by the storage layer 23 having an elliptical shape, a diamond shape, or any shape that provides proper micromagnetic state.

The disclosure is susceptible to various modifications and alternative forms, and specific examples thereof have been shown by way of example in the drawings and are herein described in detail. It should be understood, however, that the disclosure is not to be limited to the particular forms or methods disclosed, but to the contrary, the disclosure is to cover all modifications, equivalents, and alternatives.

For example, the domain wall 6 of the storage magnetization 230 can be moved within the storage layer 23 between two and ten distinct positions. Each distinct position of the domain wall 6 corresponds to a distinct value of the resistance R of the magnetic tunnel junction 2.

Similarly, the vortex center 7, and thus of the magnetic vortex 71, can be moved within the storage layer 23 between a plurality of distinct positions. A plurality of distinct resistances R can thus be obtained, each distinct resistance R being determined by the orientation and the magnitude of the storage magnetization 230 in accordance to the position of the vortex center 7. Typically, the vortex center 7 can be moved between two and ten distinct positions such as to obtain between two and ten distinct resistances R of the magnetic tunnel junction 2.

In an embodiment, the highest and lowest resistance R is obtained by saturating the storage magnetization 230 in a first direction or a second direction opposite to the first direction. Saturating the storage magnetization 230 results in moving the vortex center 7, or domain wall 6, outside the storage layer 23, i.e., the storage magnetization does not comprise the vortex center 7, or domain wall 6. The vortex center 7, or domain wall 6, can be reformed by applying the appropriate writing magnetic field 42 or by passing the appropriate spin-polarized current 33.

The domain wall 6 or the vortex center position is determined by the applied writing field 42 magnitude and direction.

### Reference numbers and symbols

- 1: magnetic random access memory (MRAM) cell
- 2: magnetic tunnel junction
- 21: reference layer
- 210: reference magnetization
- 22: barrier layer
- 23: storage layer
- 230: storage magnetization
- 3: current line
- 31: read current
- 32: heating current
- 33: spin-polarized current
- 41: write field current
- 42: write magnetic field
- 51: read field current
- 52: first read magnetic field
- 53: second read magnetic field
- 6: domain wall
- 61: magnetic domain
- 7: vortex center
- 71: magnetic vortex
- R: resistance of the magnetic tunnel junction
- R₁: minimum resistance
- R₂: first intermediate resistance
- R₃: second intermediate resistance
- R₄: maximum resistance

## Claims

1. Multilevel MRAM cell (1) comprising
a magnetic tunnel junction (2) comprising a storage layer (23) having a storage magnetization (230), a reference layer (21) having a reference magnetization (210) and a barrier layer (22) between the storage and reference layer (23, 21); the magnetic tunnel junction (2) further comprising an antiferromagnetic layer (24) exchange-coupling the storage layer (23) such as to pin the storage magnetization (230) at a low temperature threshold and free it at a high temperature threshold;
**characterized in that**
the storage magnetization (230) comprises a micromagnetic object (6, 7) that is movable within the storage layer (23) when the magnetic tunnel junction (2) is at the high temperature threshold and a write data is applied; the resistance of the magnetic tunnel junction (2) being determined by the relative position of the micromagnetic object (6, 7) in the storage layer (23).

2. The MRAM cell (1) according to claim 1, wherein
said micromagnetic object comprises a magnetic vortex (71) with a vortex center (7), the resistance of the magnetic tunnel junction (2) being determined by the position of the vortex center (7) within the storage layer (23).

3. The MRAM cell (1) according to claim 2, wherein
the storage layer (23) has an aspect ratio below 3.

4. The MRAM cell (1) according to claim 1, wherein
said micromagnetic object comprises a domain wall (6) defining two magnetic domains (61); and wherein
the resistance of the magnetic tunnel junction (2) being determined by the relative size of the two magnetic domains (61), which is determined by the domain wall position.

5. The MRAM cell (1) according to claim 4, wherein
the storage layer (23) has an aspect ratio being comprised between 1.5 and 5.

6. MRAM cell (1) according to claim 5, wherein
the storage layer (23) has a rectangular shape, a diamond shape or an elliptical shape.

7. MRAM cell (1) according to any one of claims 1 to 6, wherein the storage layer (23) has a thickness being smaller than 200 nm and preferably smaller than 20 nm.

8. MRAM cell (1) according to any one of claims 1 to 7, wherein the storage layer (23) comprises a FeNi -based alloy.

9. MRAM cell (1) according to any one of claims 1 to 8, wherein the reference magnetization (210) is fixed or is freely switchable with an external applied magnetic field.

10. Method for writing to the MRAM cell (1) **characterized by** any one of claims 1 to 9, comprising:
heating the magnetic tunnel junction to the high temperature threshold;
applying the write data (33, 41) such as to move the micromagnetic object (6, 7) of the storage magnetization (230); and
cooling the magnetic tunnel junction to a low temperature threshold such as to pin the storage magnetization (230) and the position of the micromagnetic object (6, 7).

11. The method according to claim 10, wherein
applying the write data comprises passing a write field current (41) in the MRAM cell (1) such as to generate a write magnetic field (42) adapted for moving the vortex center (7) or domain wall (6).

12. The method according to claim 10 or 11, wherein
the storage layer (23) has a rectangular shape; and wherein
moving the domain wall (6) or the vortex center (7) is performed by using the write magnetic field (42) having a magnitude being between 5 Oe and 100 Oe, and preferably between 10 Oe and 20 Oe.

13. The method according to claim 10, wherein
applying the write data comprises passing a spin-polarized current (33) in the magnetic tunnel junction (2), the domain wall (6) or the vortex center position (7) being determined by the magnitude and polarity of the spin-polarized current (33).

14. The method according to anyone of claims 10 to 13, wherein said write data (33, 41) is applied such as to move the micromagnetic object (6, 7) to a plurality of distinct positions corresponding to a plurality of distinct magnetoresistance values, respectively.

15. The method according to claim 14, wherein
said plurality of distinct positions is comprised between two and ten such that the magnetoresistance of the magnetic tunnel junction can be varied between two and ten distinct values.
